# EUROPÄISCHE PATENTANMELDUNG

(11) **EP 4 571 343 A1**
(43) Veröffentlichungstag der Anmeldung: **18.06.2025**
(21) Anmeldenummer: 24219002.3
(22) Anmeldetag: 11.12.2024
(51) Int. Cl.: G01R 33/48, G01R 33/36

(54) **SCHALTUNGSANORDNUNG ZUM KORRIGIEREN EINES EINGANGSSIGNALS UND MRT-ET-HYBRIDBILDGEBUNGSVORRICHTUNG**

(30) Priorität: 15.12.2023 DE 102023212778
(71) Anmelder: Bruker Biospin GmbH & Co. KG, 76275 Ettlingen (DE)
(72) Erfinder: MAIXNER, Michael, 76467 Bietigheim (DE)
(74) Vertreter: Kohler Schmid Möbus Patentanwälte

(57) **Zusammenfassung**

Die Erfindung betrifft eine Schaltungsanordnung (21) zum Korrigieren eines Eingangssignals (S2), wobei das Eingangssignal (S2) an einer Eingabeschnittstelle (15) der Schaltungsanordnung (21) ein Nutzsignal (S1) mit einer Nutzfrequenz und ein Störsignal mit einer Störfrequenz umfasst, wobei die Schaltungsanordnung (21) umfasst: einen Hochpassfilter (1) mit einer Grenzfrequenz, eine dem Hochpassfilter (1) nachgeschaltete und seriell mit dem Hochpassfilter (1) verschaltete invertierende Operationsverstärker-schaltung (2), eine der invertierenden Operationsverstärkerschaltung (2) nachgeschaltete und seriell mit dieser verschaltete aktive Gleichrichterschaltung (3) mit zwei parallel geschalteten Leitungspfaden, wobei jeder Leitungspfad ein gleichrichtendes Element (3a, 3b) umfasst, und eine der Gleichrichterschaltung (3) nachgeschaltete Summierverstärkerschaltung (5), wobei die Summierverstärkerschaltung einen invertierenden Eingang und einen nicht invertierenden Eingang aufweist und jeder Leitungspfad mit einem der Eingänge der Summierverstärkerschaltung (5) elektrisch verbunden ist. Hierdurch wird eine einfache und kompakte Schaltungsanordnung bereitgestellt, mit der Störsignale effektiv unterdrückt werden können.

## Beschreibung

### Hintergrund der Erfindung

Die Erfindung betrifft eine Schaltungsanordnung zum Korrigieren eines Eingangssignals, wobei das Eingangssignal an einer Eingabeschnittstelle der Schaltungsanordnung ein Nutzsignal mit einer Nutzfrequenz und ein Störsignal mit einer Störfrequenz umfasst, sowie eine Hybridbildgebungsvorrichtung mit einer solchen Schaltungsanordnung.

Insbesondere bei MRT-ET-Hybridbildgebungsvorrichtungen, die eine Magnetresonanztomografie(MRT)-Anordnung mit RF-Resonatorstruktur und Gradientenspulensystem und eine Emissions-Tomographie(ET)-Anordnung mit Detektoreinrichtung (bspw. mit Silizium-Photomultiplier(SiPM)-Arrays) umfassen, besteht die Gefahr, dass Interferenzen und gegenseitige Einflüsse von Komponenten beider Bildgebungsmodalitäten zu einer ungewünschten Beeinflussung des detektierten Signals führen. Insbesondere schnelle Gradentenschaltungen führen zu einem Störsignal, das das Nutzsignal überlagert. Dabei liegt die Störung größtenteils im Bereich unter 100 kHz und ist im Vergleich zum Nutzsignal, dessen Frequenzanteile größtenteils über 100MHz liegen, relativ niederfrequent.

WO0213689 offenbart ein Verfahren zur Verringerung der Kontamination von elektrischen Signalen, die in Gegenwart von wiederholten Interferenzverunreinigungen aufgezeichnet wurden. Das Verfahren umfasst die Gewinnung eines elektrischen Signals, wobei das elektrische Signal in Anwesenheit eines kontaminierenden Signals aufgezeichnet wurde, und die Erfassung eines Zeitsignals, das zu einem festen Zeitpunkt während des elektrischen Signals relativ zum Einsetzen des kontaminierenden Signals auftritt. Bei diesem Verfahren wird erst das Störsignal extrahiert, um es dann vom Signalgemisch zu subtrahieren. Dieses Verfahren funktioniert nur dann gut, wenn das Störsignal immer gleich aussieht und das Nutzsignal nicht synchron zum Störsignal auftritt.

Um die niederfrequenten Störungen herauszufiltern, kann prinzipiell ein Hochpassfilter verwendet werden. Je näher jedoch die Grenzfrequenz des Hochpassfilters an der Frequenz des Nutzsignals liegt, desto mehr wird das Nutzsignal verfälscht. Es muss daher zwischen Unterdrückung des Störsignals und Verfälschung des Nutzsignals abgewogen werden. Da das Integral über dem Impuls für die Signalauswertung wichtig ist, kann nur ein Filter verwendet werden, welcher eine relativ niedrige Grenzfrequenz hat. Es bleibt dann aber ein großer Teil der Störungen nach dem Filter erhalten. Eine aufwendige Zusatzschaltung ist nötig, um eine ausreichende Unterdrückung zu erreichen

### Aufgabe der Erfindung

Es ist Aufgabe der Erfindung eine einfache und kompakte Schaltungsanordnung bereitzustellen, mit der durch das Schalten von Gradienten und durch andere Einflüsse verursachte Störsignale, insbesondere bei der Verwendung von Silizium-Photomultiplier(SiPM)-Arrays als Signaldetektor, soweit unterdrückt werden können, dass eine Auswertung der Daten möglichst störungsfrei erfolgen kann.

### Beschreibung der Erfindung

Diese Aufgabe wird erfindungsgemäß gelöst durch eine Schaltungsanordnung gemäß Anspruch 1 und einer Hybridbildgebungsvorrichtung gemäß Anspruch 12.

Die erfindungsgemäße Schaltungsanordnung umfasst:
- einen Hochpassfilter mit einer Grenzfrequenz,
- eine dem Hochpassfilter nachgeschaltete und seriell mit dem Hochpassfilter verschaltete invertierende Operationsverstärkerschaltung,
- eine der invertierenden Operationsverstärkerschaltung nachgeschaltete und seriell mit dieser verschaltete aktive Gleichrichterschaltung mit zwei parallel geschalteten Leitungspfaden, wobei jeder Leitungspfad ein gleichrichtendes Element umfasst,
- eine der Gleichrichterschaltung nachgeschaltete Summierverstärkerschaltung, wobei die Summierverstärkerschaltung einen invertierenden Eingang und einen nicht invertierenden Eingang aufweist und jeder Leitungspfad mit einem der Eingänge der Summierverstärkerschaltung elektrisch verbunden ist.

Die erfindungsgemäße Schaltungsanordnung erlaubt die Verwendung von einem Hochpassfilter, dessen Grenzfrequenz nahe an der Frequenz des Nutzsignals liegt, so dass Störungen effektiv herausgefiltert werden können. Die damit verbundene Verfälschung wird bei der erfindungsgemäßen Schaltungsanordnung in Kauf genommen und durch die dem Hochpassfilter nachgeschalteten Komponenten korrigiert. Insbesondere kann der Hochpassfilter nur aus einem Kondensator bestehen.

Die erfindungsgemäße Schaltungsanordnung kann relativ kompakt aufgebaut werden, was insbesondere für Messsysteme vorteilhaft ist, die gleichzeitig sehr viele dieser Schaltungsanordnungen benötigen, wie dies beispielsweise bei einer MRT-ET-Hybridbildgebungsvorrichtung der Fall ist.

Das Nutzsignal weist vorzugsweise ein Nutzfrequenzspektrum > 50MHz, insbesondere > 100MHz auf. Das Störsignal weist vorzugsweise ein Störfrequenzspektrum < 1MHz, insbesondere < 10 kHz, auf.

Als gleichrichtende Elemente werden vorzugsweise Dioden verwendet.

Vorzugsweise sind die gleichrichtenden Elemente der Gleichrichterschaltung in unterschiedliche Richtungen geschaltet. Hierdurch werden positive und negative Flanke des Signalimpulses auf verschiedenen Pfaden verteilt. Die Information des Signals ist dann auf eine positive und eine negative Halbwelle verteilt.

Vorzugsweise ist die Grenzfrequenz des Hochpassfilters höchstens um einen Faktor 10 kleiner als die Frequenz des Nutzsignals, insbesondere um einen Faktor zwischen 5 und 10 kleiner als das Nutzsignal.

Die Grenzfrequenz des Hochpassfilters ist vorzugsweise mindestens um einen Faktor 100 größer als die Frequenz des Störsignals.

Es ist vorteilhaft, wenn die invertierende Operationsverstärkerschaltung einen niederohmigen Eingangswiderstand aufweist, vorzugsweise mit einem Widerstand kleiner als 10 Ohm. Bei der invertierenden Operationsverstärkerschaltung handelt es sich um eine niederohmige Operationsverstärkerschaltung, d.h. der Eingang des Operationsverstärkers liegt auf 0V und der Eingangswiderstand der Operationsverstärkerschaltung ist sehr klein. Durch die Kombination von Hochpassfilter und Operationsverstärker wird die Signalspannung zunächst in einen Signalstrom (am Eingang der Operationsverstärkerschaltung) und dann wieder in eine Signalspannung (am Ausgang der Operationsverstärkerschaltung) umgewandelt.

Vorzugsweise ist den gleichrichtenden Elementen jeweils ein Tiefpassfilter nachgeschaltet. Durch den Tiefpassfilter kann Information zwischengespeichert werden, was vorteilhaft bezüglich des nachfolgenden Zusammenführens der Teilsignale ist.

Bei einer besonders bevorzugten Ausführungsform der erfindungsgemäßen Schaltungsanordnung ist eine Integratorschaltung mit Resetfunktion mit einem der Summierverstärkerschaltung nachgeschaltetem Integrator und mit einem Reset-Schaltzweig vorgesehen, wobei der Reset-Schaltzweig dazu eingerichtet ist, ein Steuersignal nach der invertierenden Operationsverstärkerschaltung, vorzugsweise zwischen der invertierenden Operationsverstärkerschaltung und der Gleichrichterschaltung abzugreifen, und wobei der Reset-Schaltzweig einen Schalter umfasst, der einen Kondensator des Integrators überbrückt. Der Schalter wird mit Hilfe des abgegriffenen Steuersignals gesteuert. Damit kann die Zeit zwischen den Nutzsignalimpulsen "stumm" geschaltet werden. Dazu wird ein Steuersignal nach der invertierenden Operationsverstärkerschaltung (= Steuereingang), wo das Störsignal schon weitestgehend herausgefiltert ist, abgegriffen und ein geeigneter Schwellwert zur Aktivierung des Schalters gewählt. Auf diese Weise kann die Störungsunterdrückung weiter verbessert werden.

Vorzugsweise umfasst der Reset-Schaltzweig ein Verzögerungsglied. Das Verzögerungsglied bewirkt, dass der Schalter nach Unterschreitung des Schwellwerts noch kurz offen bleibt, damit der gesamte verarbeitete Nutzsignalimpuls am Signalausgang ankommt.

Vorzugsweise ist der Summierverstärkerschaltung ein Tiefpassfilter nachgeschaltet. Der Tiefpassfiltere bewirkt eine Integration (Glättung) des Signals.

Vorzugsweise wird die erfindungsgemäße Schaltungsanordnung zum Korrigieren eines Eingangssignals verwendet, wobei das Eingangssignal ein Nutzsignal mit einem Nutzfrequenzspektrum und ein Störsignal mit einem Störfrequenzspektrum umfasst.

Besonders bevorzugt wird die erfindungsgemäße Schaltungsanordnung zum Korrigieren eines Eingangssignals einer Hybridbildgebungsvorrichtung umfassend eine Magnetresonanztomografie (MRT)-Anordnung mit einem Gradientenspulensystem verwendet.

Die Erfindung betrifft auch eine Hybridbildgebungsvorrichtung umfassend eine Magnetresonanztomografie(MRT)-Anordnung mit einem Gradientenspulensystem, eine Emissions-Tomographie(ET)-Anordnung mit einer Detektoreinrichtung umfassend einen Photosensor, wobei die ET- und MR-Anordnungen eine gemeinsame Bohrung aufweisen, in welcher die Detektoreinrichtung angeordnet ist, und eine Signalleitung, welche die Nutzsignale von der Detektoreinrichtung zu einer Bildverarbeitungseinheit außerhalb der Bohrung leitet, wobei die Bildverarbeitungseinheit eine zuvor beschriebene Schaltungsanordnung umfasst.

Die Störungen, die das PET Signal beeinflussen, kommen hauptsächlich von den Gradientenschaltungen der MRT-Anordnung. Das Schalten der Gradienten induzieren in die PET-Signalleitungen ein Störsignal, das mit der erfindungsgemäßen Schaltungsanordnung herausgefiltert werden kann.

Bei der Emissions-Tomographie(ET)-Anordnung handelt es sich vorzugsweise um eine Positronen-Emissions-Tomografie (PET) Anordnung.

Vorzugsweise ist der Photosensor ein Silizium-Photomultiplier und das Nutzsignal ist analog.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt ein Blockschaltbild einer erfindungsgemäßen Schaltungsanordnung ohne Integratorschaltung mit Resetfunktion.
- Fig. 2: zeigt ein Blockschaltbild einer erfindungsgemäßen Schaltungsanordnung mit Integratorschaltung mit Resetfunktion.
- Fig. 3: zeigt eine Signalkombination einzelner und schnell aufeinander folgender Nutzsignale unterschiedlicher Amplituden an unterschiedlichen Stellen der erfindungsgemäßen Schaltungsanordnung.
- Fig. 4: zeigt einen vergrößerten Auszug aus der Signalkombination aus Fig. 3.
- Fig. 5: zeigt einen gegenüber Fig. 4 weiter vergrößerten Auszug aus der Signalkombination aus Fig. 3.
- Fig. 6: zeigt eine Schnittdarstellung der erfindungsgemäßen Hybridbildgebungsvorrichtung senkrecht zur z-Richtung.
- Fig. 7: zeigt eine Schnittdarstellung einer Hälfte der erfindungsgemäßen Hybridbildgebungsvorrichtung längs der z-Richtung.

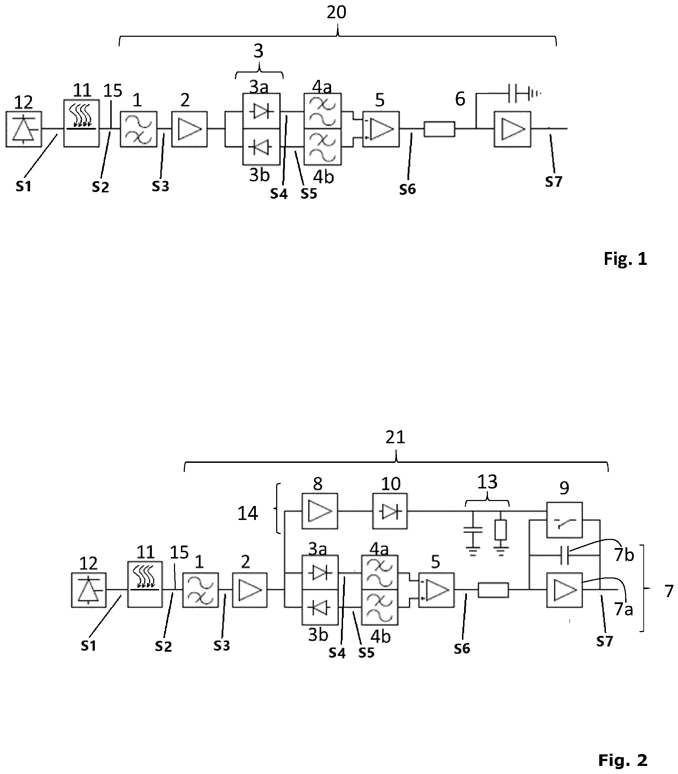

**Fig. 1** zeigt eine Detektoreinrichtung **12,** die mit einer einfachen Ausführungsform der erfindungsgemäßen Schaltungsanordnung **20** über eine Signalleitung **30** verbunden ist. Am Eingang (Eingabeschnittstelle 15) der Schaltungsanordnung 20 (Signaleingang) liegt ein Eingangssignal **S2** an, das eine Überlagerung aus einem durch die Detektoreinrichtung 12 detektiertem Nutzsignal **S1** und einer Störung 11 ist, welche zwischen der Detektoreinrichtung 12 und der erfindungsgemäßen Schaltungsanordnung 20 ein Störsignal in die Signalleitung 30 einkoppelt.

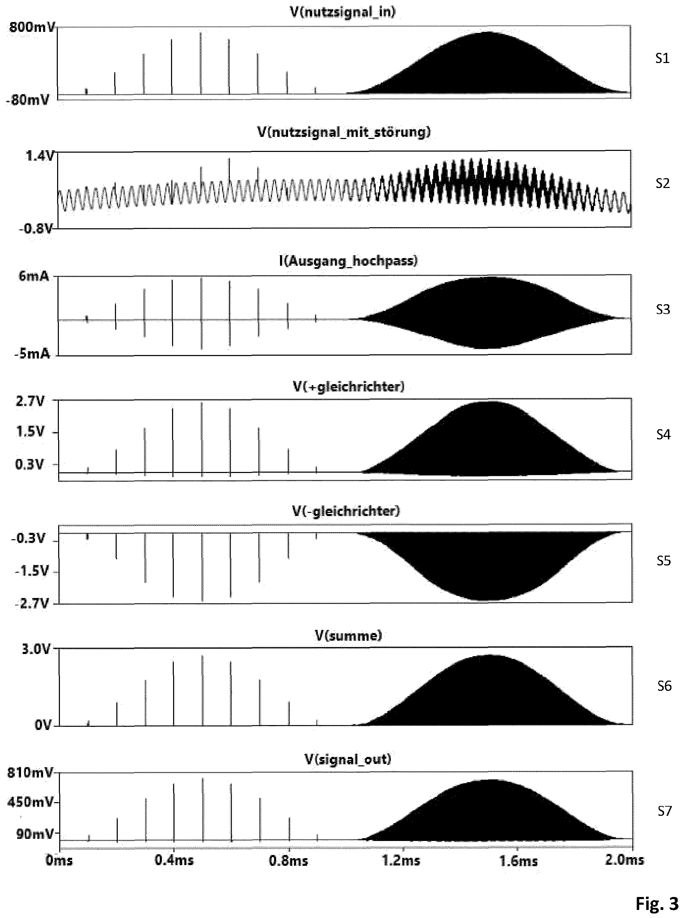

Das Nutzsignal S1 sowie Signale **S2-S7,** die an den verschiedenen Komponenten der Schaltungsanordnung 20 anliegen sind in **Fig. 3-5** dargestellt.

Durch einen Hochpassfilter **1** werden zunächst niederfrequente Störsignale herausgefiltert. Der Hochpassfilters 1 wird durch eine niederohmige Operationsverstärkerschaltung **2** abgeschlossen. Durch die Kombination von Hochpassfilter 1 und Operationsverstärkerschaltung 2 wird die Signalspannung zunächst in einen Signalstrom S3 (am Eingang der Operationsverstärkerschaltung) und dann wieder in eine Signalspannung (am Ausgang der Operationsverstärkerschaltung) umgewandelt. Dabei wird das Signal S3 durch Faltungseffekte verfälscht. Das Signal am Ausgang der invertierenden Operationsverstärkerschaltung (in den Fig. 3-5 nicht dargestellt) besteht aus einer positiven und einer negativen Schwingung, welche die Flanken des Nutzsignalimpulses S1 repräsentieren. Störsignale sind hier (und auch bereits in S3) schon sehr weit unterdrückt.

Der niederohmige Operationsverstärkerschaltung 2 nachgeschaltet ist eine, insbesondere aktive, Gleichrichterschaltung 3. Die Gleichrichterschaltung 3 umfasst zwei parallel geschalteten Leitungspfade, wobei jeder Leitungspfad ein gleichrichtendes Element **3a, 3b** umfasst. Bei den gleichrichtenden Elementen 3a, 3b kann es sich bspw. um Dioden handeln, die in den beiden Pfaden entgegengesetzt verschaltet sind, so dass die Information des hochpassgefilterten Signals S3 auf eine positive und eine negative Halbwelle (zeitversetzte Teilsignale **S4, S5**) verteilt werden. Optionale Tiefpassfilter **4a, 4b** in den jeweiligen Pfaden ermöglichen die Zwischenspeicherung von Information. Durch eine Summierverstärkerschaltung **5** werden die Teilsignale S4, S5 wieder zusammengeführt, indem eines der Teilsignale S4, S5 invertiert und mit dem anderen Teilsignal summiert wird. Durch die Aufteilung des Signals S3 in Teilsignale S4, S5 mittels der Gleichrichterschaltung 3 und der nachfolgenden Invertierung eines der Teilsignale S4, S5 durch die Summierverstärkerschaltung 5 resultieren also zwei positive Teilsignale (in Fig. 3-5 nicht dargestellt) die dann am Verstärkerausgang zusammengeführt werden (**S6**). Durch einen nachgeschalteten Tiefpassfilter **6** (RC-Glied) resultiert am Signalausgang ein geglättetes Ausgangssignal **S7,** dessen Amplitude proportional zur Amplitude des Nutzsignals S1 ist.

Insbesondere bei MRT-ET-Hybridbildgebungsvorrichtungen umfasst das Nutzsignal S1 Impulse (Nutzsignalimpulse). Zwischen diesen Nutzsignalimpulsen ist das Nutzsingal 0 und das Eingangssignal S2 enthält daher zwischen diesen Nutzsignalimpulsen lediglich Störsignale. Diese können durch eine Integratorschaltung 7, 14 mit Resetfunktion unterdrückt werden. Eine entsprechende Schaltungsanordnung ist in **Fig. 2** gezeigt. Fig. 2 zeigt die Detektoreinrichtung 12 sowie eine besonders bevorzugten Ausführungsform der erfindungsgemäßen Schaltungsanordnung **21** mit einer solchen Integratorschaltung 7, 14 mit Resetfunktion. Die in Fig. 2 gezeigte Ausführungsform der Schaltungsanordnung 21 umfasst dazu zusätzlich zu den in Fig. 1 beschriebenen Komponenten einen Reset-Schaltzweig **14** und einen Integrator **7.** Der Integrator 7 umfasst einen Operationsverstärker 7a und einen zum Operationsverstärker 7a parallel geschalteten Kondensator **7b.** Der Reset-Schaltzweig 14 umfasst einen Schalter **9,** der den Kondensator 7b des Integrators 7 überbrückt. Wenn der Schalter 9 geschlossen ist, ist der Kondensator 7b des Integrators 7 kurzgeschlossen und der hochohmige Verstärkerausgang des Operationsverstärkers 7a ist mit dessen Verstärkereingang verbunden. Es resultiert eine Ausgangsspannung von 0V.

Der Reset-Schaltzweig 14 ist so aufgebaut, dass der Schalter 9 des Reset-Schaltzweiges geschlossen wird, wenn kein Nutzsignal anliegt. In der Zeit zwischen den Nutzsignalimpulsen wird die Schaltungsanordnung 21 also "stumm" geschaltet (Resetphase). Als Steuersignal dient das Ausgangssignal der Operationsverstärkerschaltung 2, das nach der invertierenden Operationsverstärkerschaltung 2 (= Steuereingang der Integratorschaltung 7, 14) abgegriffen wird. An dieser Stelle ist das Störsignal schon weitestgehend herausgefiltert. Darüber hinaus wird ein Schwellwert zur Aktivierung des Schalters 9 festgelegt.

Die Integratorschaltung ist so eingerichtet, dass bei Unterschreitung des Schwellwertes der Schalter 9 geschlossen wird, so dass eine Ausgangsspannung von 0V als Ausgangssignal S7 ausgegeben wird, wie oben beschrieben. Störsignale können somit zwischen den Nutzsignalimpulsen vollständig beseitigt werden. Bei einem Anstieg des Steuersignals über den Schwellwert schaltet der Reset-Schaltzweig 14 den Integrator 7 auf "Integrieren" (Abtastphase), d.h. Schalter 9 wird geöffnet und als Ausgangssignal S7 wird das Signal, das die Komponenten 1-6 gerade durchlaufen hat, ausgegeben. Unterschreitet das Steuersignal den Schwellwert wieder, wird der Schalter 9 wieder geschlossen. Mittels des Verzögerungsglieds 13 (hier: Parallelschaltung von Kapazität und Widerstand, die jeweils auf einem Referenzpotential liegen) wird bewirkt, dass, solange Spannung am Widerstand des Verzögerungsglied 13 anliegt, der Kondensator des Verzögerungsglied 13 geladen wird und der Schalter 9 geöffnet bleibt, damit das Ausgangssignal S7 während der gesamten Dauer des Nutzsignalimpulses durchgelassen wird. Danach wird der Signalweg unterbrochen und die Ausgangsspannung ist wieder 0V. Somit kann zwischen einer Abtastphase (Schalter 9 geöffnet) und einer Resetphase (Schalter 9 geschlossen) geschaltet werden.

In der Abtastphase verändert sich die Ausgangsspannung (Ausgangssignal) der Schaltung in Abhängigkeit von der Eingangsspannung. Genauer gesagt spiegelt die Ausgangsspannung das Integral über dem Eingangsspannungsverlauf wieder. In der Resetphase (Schalter 9 leitend) geht die Ausgangsspannung sofort auf OV, egal welche Eingangsspannung anliegt.

Bei der in Fig. 2 gezeigten Ausführungsform umfasst der Reset-Schaltzweig 14 zusätzlich einen Signalverstärker **8** (z.B. einen Transistorverstärker) zur Verstärkung des abgegriffenen Steuersignals und einen Gleichrichter **10** zum Filtern von positiven Peaks des Steuersignals, wobei diese Komponenten in Serie mit dem Schalter 9 und dem Verzögerungsglied 13 verschaltet sind.

**Fig. 3** zeigt oben eine Signalkombination S1 einzelner Nutzsignale mit relativ großem zeitlichen Abstand zueinander (links) und schnell aufeinander folgender Nutzsignale (rechts) mit unterschiedlichen Amplituden. In den darauffolgenden Zeilen sind die entsprechenden Signale S2-S7 dargestellt.

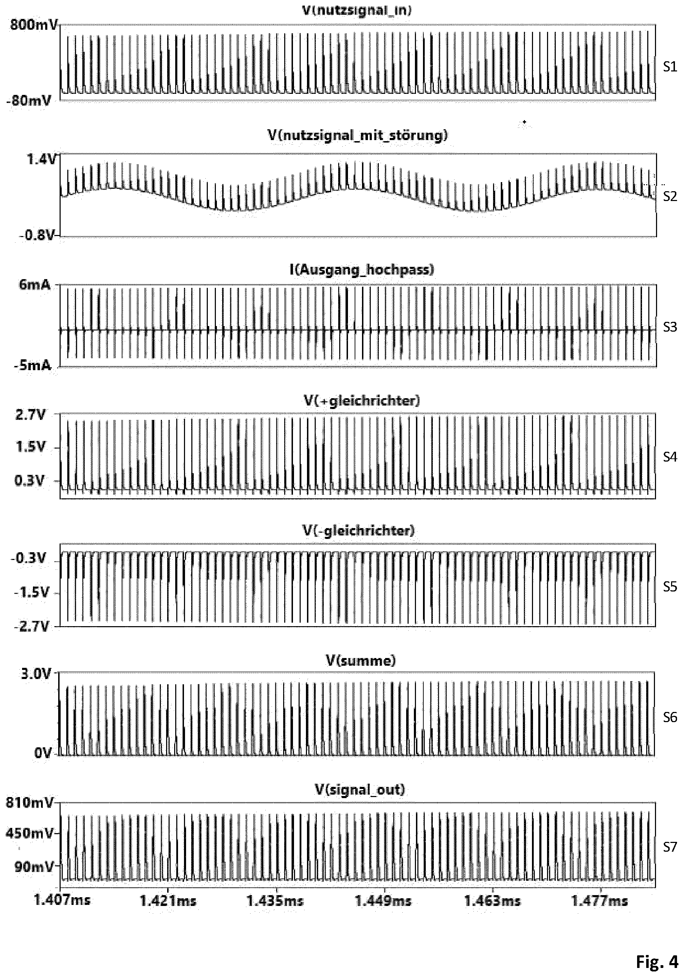

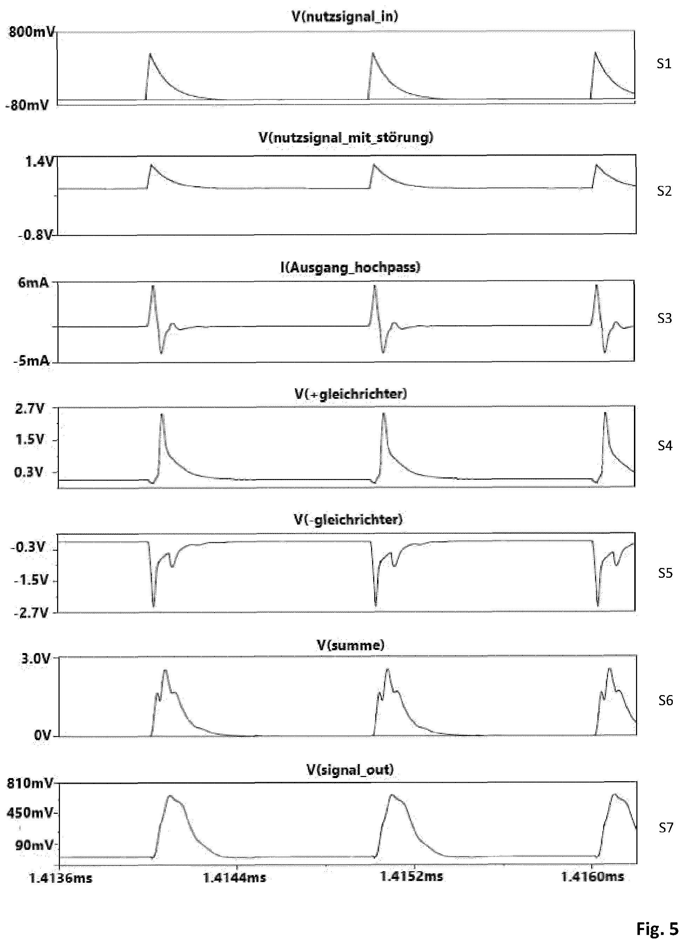

**Fig. 4** und **Fig. 5** zeigen oben jeweils einen vergrößerten Ausschnitt der schnell aufeinander folgenden Nutzsignale aus Fig. 3. In den darauffolgenden Zeilen sind die entsprechenden Ausschnitte der Signale S2-S7 dargestellt.

Aus Fig. 4 kann man gut erkennen, dass durch den Hochpassfilter 1 die in Signal S2 noch vorhandene niederfrequente Störung effektiv herausgefiltert wird und im Signal S3 nicht mehr vorhanden ist. In Fig. 5 ist die dabei entstehende Verfälschung durch den Hochpassfilter 1 zu sehen: Hier ist ein Teil des Signals S3 ins Negative gefaltet. Durch die Gleichrichterschaltung 3 werden die positiven Teile und die negativen Teile des Signals S3 in zwei (invertierte) Teilsignale S4, S5 aufgeteilt. Dies ermöglicht es, eines der Teilsignale S4, S5 noch einmal zu invertieren, so dass durch eine anschließende Aufsummierung der Teilsignale die Verfälschung durch den Hochpassfilter 1 weitestgehend kompensiert werden kann.

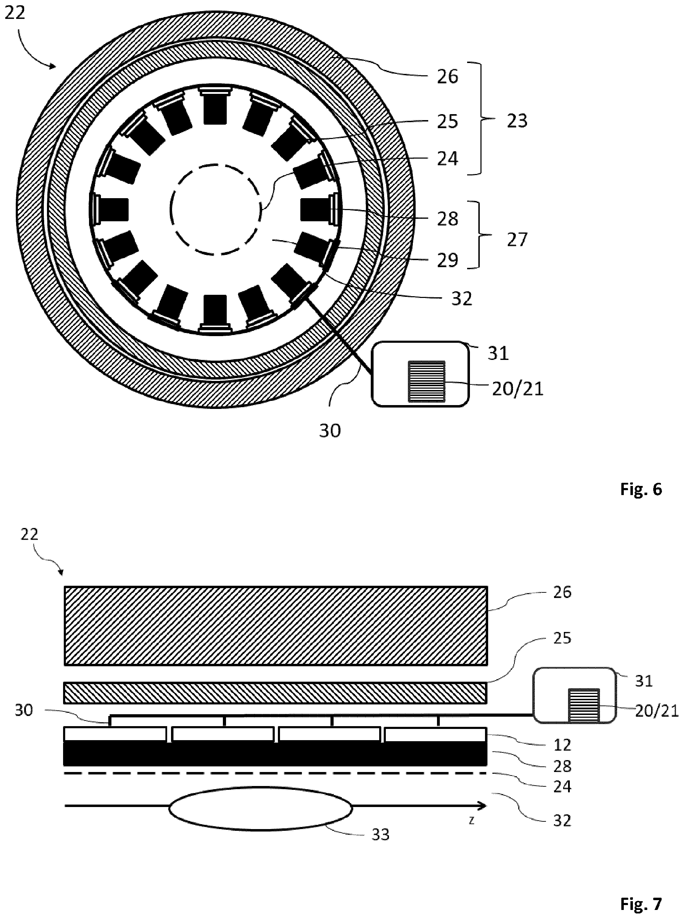

**Fig. 6** zeigt eine Hybridbildgebungsvorrichtung **22** gemäß der vorliegenden Erfindung mit einer MRT-Anordnung **23** und einer Emissions-Tomographie(ET)-Anordnung **27.** Die MRT-Anordnung **23** umfasst neben einer RF-Resonatorstruktur **24** ein Gradientenspulensystem **25** mit einer Längsachse **z** und eine Magnetspulenanordnung **26** zur Erzeugung eines statischen Magnetfeldes. Die ET-Anordnung **27** umfasst einen Szintillator **28** und die Detektoreinrichtung **12** (insbesondere einen Photosensor), die radial zwischen dem Gradientenspulensystem 25 und der RF-Resonatorstruktur 24 in einer Bohrung der MRT-Anordnung 23 und der ET-Anordnung 27 angeordnet ist.

Die Detektoreinrichtung **12** ist über die Signalleitung 30 mit einer Bildverarbeitungseinheit **31** außerhalb der Bohrung 34 verbunden. Die Bildverarbeitungseinheit beinhaltet die erfindungsgemäße Schaltungsanordnung **20, 21,** um die Störsignale der MR-Apparatur zu unterdrücken.

**Fig. 7** zeigt eine Schnittdarstellung längs einer Hälfte der Hybridbildgebungsvorrichtung **22** mit einem Untersuchungsobjekt **33,** wobei nach oben die radiale Richtung r und nach rechts die axiale Richtung der Längsachse z aufgetragen ist.

### Bezuaszeichenliste

- 1: Hochpassfilter
- 2: invertierende Operationsverstärkerschaltung (niederohmiger Verstärker)
- 3: Gleichrichterschaltung
- 3a: positives gleichrichtendes Element der Gleichrichterschaltung
- 3b: negatives gleichrichtendes Element der Gleichrichterschaltung
- 4a: Tiefpassfilter für positives gleichrichtendes Element
- 4b: Tiefpassfilter für negatives gleichrichtendes Element
- 5: Summierverstärkerschaltung
- 6: Tiefpassfilter
- 7: Integrator
- 7a: Operationsverstärker des Integrators
- 7b: Kapazität des Integrators
- 8: Signalverstärker des Reset-Schaltkreises
- 9: Schalter des Reset-Schaltkreises
- 10: Gleichrichter des Reset-Schaltkreises
- 11: Einkopplungen der Störsignale
- 12: Detektoreinrichtung mit Photosensor
- 13: Verzögerungsglied des Reset-Schaltkreises
- 14: Reset-Schaltzweig
- 15: Eingabeschittstelle
- 20: Schaltungsanordnung ohne für Integrator mit Resetfunktion
- 21: Schaltungsanordnung mit für Integrator mit Resetfunktion
- 22: MR/PET-Hybridbildgebungsvorrichtung
- 23: Magnetresonanztomografie (MRT)-Anordnung
- 24: RF-Resonatorstruktur/MR-HF-Spule
- 25: Gradientenspulensystem
- 26: Magnetspulenanordnung
- 27: Emissions-Tomographie(ET)-Anordnung
- 28: Szintillator
- 29: Photosensor
- 30: Signalleitung
- 31: Bildverarbeitungseinheit
- 32: Bohrung
- 33: Untersuchungsobjekt
- 34: Bohrung
- S1: Nutzsignal
- S2: Eingangssignal
- S3: Signal nach Hochpassfilter
- S4: Teilsignal nach positivem gleichrichtendem Elementen
- S5: Teilsignal nach negativem gleichrichtendem Elementen
- S6: Signal nach Summierverstärkerschaltung
- S7: Ausgangssignal

### Literaturliste

WO0213689A2

## Patentansprüche

1. Schaltungsanordnung (20, 21) (20, 21) zum Korrigieren eines Eingangssignals (S2), wobei das Eingangssignal (S2) an einer Eingabeschnittstelle (15) der Schaltungsanordnung (20, 21) ein Nutzsignal (S1) mit einer Nutzfrequenz und ein Störsignal mit einer Störfrequenz umfasst, wobei die Schaltungsanordnung (20, 21) umfasst:
• einen Hochpassfilter (1) mit einer Grenzfrequenz,
• eine dem Hochpassfilter (1) nachgeschaltete und seriell mit dem Hochpassfilter (1) verschaltete invertierende Operationsverstärkerschaltung (2),
• eine der invertierenden Operationsverstärkerschaltung (2) nachgeschaltete und seriell mit dieser verschaltete aktive Gleichrichterschaltung (3) mit zwei parallel geschalteten Leitungspfaden, wobei jeder Leitungspfad ein gleichrichtendes Element (3a, 3b) umfasst,
• eine der Gleichrichterschaltung (3) nachgeschaltete Summierverstärkerschaltung (5), wobei die Summierverstärkerschaltung einen invertierenden Eingang und einen nicht invertierenden Eingang aufweist und jeder Leitungspfad mit einem der Eingänge der Summierverstärkerschaltung (5) elektrisch verbunden ist.

2. Schaltungsanordnung (20, 21) nach Anspruch 1, **dadurch gekennzeichnet, dass** die gleichrichtenden Elemente (3a, 3b) der Gleichrichterschaltung (3) in unterschiedliche Richtungen geschaltet sind.

3. Schaltungsanordnung (20, 21) nach einem der vorhergehenden Ansprüche, **dadurch gekennzeichnet, dass** die Grenzfrequenz des Hochpassfilters (1) höchstens um einen Faktor 10 kleiner ist als die Frequenz des Nutzsignals.

4. Schaltungsanordnung (20, 21) nach einem der vorhergehenden Ansprüche, **dadurch gekennzeichnet, dass** die Grenzfrequenz des Hochpassfilters (1) mindestens um einen Faktor 100 größer ist als die Frequenz des Störsignals.

5. Schaltungsanordnung (20, 21) nach einem der vorhergehenden Ansprüche, **dadurch gekennzeichnet, dass** die invertierende Operationsverstärkerschaltung (2) einen niederohmigen Eingangswiderstand, vorzugsweise mit einem Widerstand kleiner als 10 Ohm, aufweist.

6. Schaltungsanordnung (20, 21) nach einem der vorhergehenden Ansprüche, **dadurch gekennzeichnet, dass** den gleichrichtenden Elementen (3a, 3b) jeweils ein Tiefpassfilter (4a, 4b) nachgeschaltet ist.

7. Schaltungsanordnung (21) nach einem der Ansprüche 1 bis 6, **dadurch gekennzeichnet, dass** eine Integratorschaltung mit Resetfunktion mit einem der Summierverstärkerschaltung (5) nachgeschaltetem Integrator (7) und mit einem Reset-Schaltzweig (14) vorgesehen ist,
wobei der Reset-Schaltzweig (14) dazu eingerichtet ist, ein Steuersignal nach der invertierenden Operationsverstärkerschaltung (2), vorzugsweise zwischen der invertierenden Operationsverstärkerschaltung (2) und der Gleichrichterschaltung (3), abzugreifen, und
wobei der Reset-Schaltzweig (14) einen Schalter (9) umfasst, der einen Kondensator (7b) des Integrators (7) überbrückt.

8. Schaltungsanordnung (21) nach Anspruch 7, **dadurch gekennzeichnet, dass** der Reset-Schaltzweig (14) ein Verzögerungsglied (13) umfasst.

9. Schaltungsanordnung (20) nach einem der Ansprüche 1 bis 6, **dadurch gekennzeichnet, dass** der Summierverstärkerschaltung (5) ein Tiefpassfilter (6) nachgeschaltet ist.

10. Verwendung der Schaltungsanordnung (20, 21) nach einem der Ansprüche 1 bis 9 zum Korrigieren eines Eingangssignals S2, wobei das Eingangssignal ein Nutzsignal (S1) mit einem Nutzfrequenzspektrum und ein Störsignal mit einem Störfrequenzspektrum umfasst.

11. Verwendung nach Anspruch 10 in einer Hybridbildgebungsvorrichtung umfassend eine Magnetresonanztomografie (MRT)-Anordnung (23) mit einem Gradientenspulensystem (25).

12. Hybridbildgebungsvorrichtung (22) umfassend
eine Magnetresonanztomografie (MRT)-Anordnung (23) mit einem Gradientenspulensystem (25),
eine Emissions-Tomographie(ET)-Anordnung (27) mit einer Detektoreinrichtung (12) umfassend einen Photosensor,
wobei die ET- und MR-Anordnungen eine gemeinsame Bohrung (32) aufweisen, in welcher die Detektoreinrichtung (12) angeordnet ist,
eine Signalleitung (30), welche die Nutzsignale (S1) von der Detektoreinrichtung (12) zu einer Bildverarbeitungseinheit (31) außerhalb der Bohrung (32) leitet, wobei die Bildverarbeitungseinheit (31) eine Schaltungsanordnung (20, 21) nach einem der Ansprüche 1 bis 9 umfasst.

13. Hybridbildgebungsvorrichtung (22) nach Anspruch 12, wobei Emissions-Tomographie(ET)-Anordnung (27) eine Positronen-Emissions-Tomografie (PET)-Anordnung ist.

14. Hybridbildgebungsvorrichtung (22) nach Anspruch 13, wobei der Photosensor (12) ein Silizium-Photomultiplier ist und das Nutzsignal (S1) analog ist.
